# EUROPEAN PATENT APPLICATION

(11) **EP 4 625 108 A1**
(43) Date of publication of application: **01.10.2025**
(21) Application number: 25167575.7
(22) Date of filing: 31.03.2025
(51) Int. Cl.: G06F 1/20

(54) **COMPUTING POWER HOST AND VIRTUAL CURRENCY MINING MACHINE**

(30) Priority: 29.03.2024 CN 202410376997
(71) Applicant: Bitdeer Semiconductor Technology PTE. LTD., 049514 Singapore (SG)
(72) Inventor: YANG, Senfeng, 049514 Singapore (SG); DAI, Qiang, 049514 Singapore (SG); LI, Weiguo, 049514 Singapore (SG)
(74) Representative: Wang, Bo

(57) **Abstract**

The present application provides a computing host, the supercomputing unit comprises a first heat sink, a computing board and a second heat sink; the first heat sink and the second heat sink are each provided with a flow guiding surface at a portion close to the air inlet, the flow guiding surface is an inclined surface, and the inclined surface extends at least from an outer side surface of the heat dissipation fins away from the heat dissipation panel to a side close to the heat dissipation panel; the flow guiding surface is at least partially located on an outer side of the chip region close to the air inlet. The computing host can reduce the deposition of foreign matter such as dust on end faces of heat sinks, thereby improving the heat dissipation effect of the whole computing board, reducing the noise of the whole system.

## Description

### FIELD

The present application relates to the field of data processing technologies, and particularly to a computing power host and virtual currency mining machine.

### BACKGROUND

The crucial computing chips in a server generate a lot of heat during operation. If such heat is not transferred to the external in time, the performance and service life of the computing chips will be affected, and even a dead halt of an apparatus and a crash of a system etc. will be caused. In the prior art, the server is provided with a heat dissipation fan on front and rear end walls of the housing, to transfer the heat generated by the computing chips on the computing board to the external via an airflow. However, many computing chips are distributed on the computing board, and these computing chips are disposed in the airflow channel; when the airflow flows by the computing chips, the temperature of the airflow varies substantially, particularly at positions adjacent to an air inlet and adjacent to an air outlet, thereby causing the temperature of the computing chips uneven so that it is very difficult for the computing chips to achieve an ideal operation state.

To make the temperatures on the computing chips even, some servers are provided with a heat sink having fins directly above the computing chips on the computing board, and the fins located upstream are set to have a variable-cross-section structure, for example, part of the windward surface is set as an inclined surface or a stepped surface, so that the area of the fins on the computing chips varies and the temperature on the computing chips is made consistent. However, in this way, although the temperature on the computing chips is relatively even, the heat dissipation area of the whole heat sink is necessarily reduced, and the reduction of the overall temperature is limited; in addition, on account of the structure that the part of the windward surface is the inclined surface or the stepped surface, foreign matter such as dust is prone to be deposited on the end face of the heat sink, particularly adjacent to the first row of computing chips, which not only causes the obstruction of the airflow channel, but also affects the heat transfer effect of the first row of chips. Therefore, in practice, this structure is not ideal for the overall heat dissipation effect and the local heat conduction effect.

### SUMMARY

Based on the present state of the art, a main object of the present application is to provide a computing assembly and a server, to reduce the deposition of foreign matter such as dust on end faces of heat sinks, thereby improving the heat dissipation effect of the whole computing board and the heat conduction effect everywhere, reducing the noise of the whole system, and improving the comfort of human ears.

The present application employs the following technical solutions to achieve the above object:
A first aspect of the present application provides a computing host comprising a housing and a supercomputing unit, the housing having an air inlet and an air outlet; the supercomputing unit being mounted in the housing and is located between the air inlet and the air outlet;
the supercomputing unit comprises a first heat sink, a computing board and a second heat sink which are disposed in sequence;
the computing board comprises a substrate and a plurality of computing chips, a chip region is provided on a first surface of the substrate, and the plurality of computing chips are disposed at intervals in the chip region in a first direction in which the air inlet and the air outlet are opposite to each other;
the first heat sink and the second heat sink each comprise a heat dissipation panel and a plurality of heat dissipation fins, the plurality of heat dissipation fins are disposed on a first surface of the heat dissipation panel, and all said heat dissipation fins extend in said first direction;
wherein the first heat sink and the second heat sink are each provided with a flow guiding surface at a portion close to the air inlet, the flow guiding surface is an inclined surface inclined with respect to a second surface of the heat dissipation panel, one end of the inclined surface away from the air inlet is inclined in a direction away from the second surface of the heat dissipation panel as compared with the other end of the inclined surface, and the inclined surface extends at least from an outer side surface of the heat dissipation fins away from the heat dissipation panel to a side close to the heat dissipation panel;
the second surfaces of respective heat dissipation panels of the first heat sink and the second heat sink face towards the substrate, and the flow guiding surface is at least partially located on an outer side of the chip region close to the air inlet in the first direction.

Preferably, an angle between the inclined surface and the second surface of the heat dissipation panel is in a range of 30°-60°.

Preferably, an angle between the inclined surface and the second surface of the heat dissipation panel is 45°.

Preferably, in a projection in the thickness direction of the substrate, a projection of the flow guiding surface and the computing chip closest to the air inlet have an overlapping region, and a size of the overlapping region in the first direction is less than or equal to 1/4 of the size of the computing chip.

Preferably, in a projection in the thickness direction of the substrate, a terminating end on the projection of the flow guiding surface away from the air inlet coincides with a first edge of the computing chip closest to the air inlet, and the first edge is an edge of the computing chip close to the air inlet.

Preferably, a distance between an end of the flow guiding surface close to the air inlet and the first surface of the heat dissipation panel is less than or equal to 2 mm.

Preferably, an end of the flow guiding surface close to the air inlet extends to the second surface of the heat dissipation panel.

Preferably, in the first heat sink and the second heat sink, a distance between two said adjacent heat dissipation fins is in a range of 1 mm to 3 mm.

Preferably, a size of extension of the heat sink beyond the chip region is in a range of 15 cm to 22 cm.

Preferably, the first heat sink is located on a side of the substrate where the computing chips are disposed;
the first heat sink further comprises a thermally conductive strip, the thermally conducive strip is located on a side of the heat dissipation panel close to the substrate, and the thermally conductive strip extends in the first direction; the first heat sink is fitted against the computing chips via the thermally conductive strip.

Preferably, a thermal interface material is further provided between the thermally conductive strip and the computing chips.

Preferably, the second heat sink is provided with positioning posts facing towards the substrate; positioning holes corresponding to the positioning posts are provided on both the substrate and the first heat sink, and the respective positioning posts are inserted in and fitted with the respective positioning holes.

Preferably, the first heat sink is located on a side of the substrate where the computing chips are disposed; the substrate is provided with a first mounting hole, the first heat sink is provided with a second mounting hole corresponding to the first mounting hole, and the second heat sink is provided with a locking hole corresponding to the first mounting hole; wherein the second mounting hole is a stepped hole;
the supercomputing unit further comprises a locking member and an extension spring, the locking member comprises a screw head and a screw shank, the screw shank is locked with the locking hole via the corresponding second mounting hole and the first mounting hole, and the extension spring is located between the screw head and a stepped surface of the stepped hole.

Preferably, a plurality of said supercomputing units are disposed side by side in the housing, the first heat sink of one of two said adjacent supercomputing units 20 is adjacent to the second heat sink of the other, and a distance between the two said adjacent supercomputing units is in a range of 2 mm-4 mm.

A second aspect of the present application provides a server comprising the computing host according to any of the above solutions.

In the computing host according to the present application, in a first aspect, the first heat sink and the second heat sink are respectively disposed on both sides of the computing board, the two heat sinks both extend beyond the computing chips on the side close to the air inlet, and the inclined air guiding surface is disposed on each of the heat sinks, so that the flow guiding surface is disposed on the entire heat dissipation fin at least in the thickness direction of the computing board. As such, the area of the end face of each heat sink on the side close to the air inlet is reduced, so that when the air flow contacts the heat sink, the blocking of the end face against foreign matter such as dust is reduced, the foreign matter such as dust can flow more easily along with the airflow towards the air outlet, and then be carried out of the housing; meanwhile, the inclined flow guiding surface can guide the airflow so that foreign matter such as dust flows along the flow guiding surface toward the air outlet, thereby further reducing the possibility of foreign matter such as dust being deposited on the end face of each heat sink. In a second aspect, since the flow guiding surface of the present application extends at least partially beyond the chip region, the flow guiding surface is provided without substantially reducing the heat dissipation area above the computing chips, and can also increase the heat dissipation area on the side of the air intake end, thereby better improving the heat dissipation performance of the whole heat sink, so that the whole computing host can always be in an ideal state. In a third aspect, such a heat sink with the inclined flow guiding surface in the present application can also reduce the system impedance, the turbulence is reduced in a way that the airflow is guided by the flow guiding surface, and thus the noise is reduced. As compared with the high-frequency harsh noise generated by the heat sink whose windward surface is wholly at a right angle to the second surface of the heat dissipation panel, the heat sink of the present application has a reduced noise frequency due to the reduced turbulence, so that the noise effect of the entire computing host and the server can be improved, and the comfort of human hearing can be enhanced.

Other advantageous effects of the present application will be described by introducing specific technical features and technical solutions in specific embodiments. Those skilled in the art can understand the advantageous technical effects resulting from the technical features and technical solutions by reading through the introduction of these technical features and technical solutions.

### BRIEF DESCRIPTION OF THE DRAWINGS

Hereinafter, preferred embodiments of the present application will be described with reference to the following figures.
FIG. 1 is a structural schematic view of a preferred embodiment of a computing host according to the present application;
FIG. 2 is a cross-sectional view of a preferred embodiment of the computing host according to the present application;
FIG. 3 is a partially enlarged view of portion I of Fig. 2;
FIG. 4 is a structural schematic view of a preferred embodiment of a supercomputing unit in the computing host according to the present application;
FIG. 5 is an exploded view of a preferred embodiment of the supercomputing unit in the computing host according to the present application;
FIG. 6 is a structural schematic view of a preferred embodiment of a first heat sink in the computing host according to the present application;
FIG. 7 is a structural schematic view of a preferred embodiment of the first heat sink and a computing board in the computing host according to the present application;
FIG. 8 is a partially enlarged view of portion II of Fig. 7;
FIG. 9 is a partially enlarged view of portion II of Fig. 7 corresponding to another preferred embodiment of the supercomputing unit in the computing host according to the present application;
FIG. 10 is a partially enlarged view of portion II of Fig. 7 corresponding to a further preferred embodiment of the supercomputing unit in the computing host according to the present application;
FIG. 11 is a structural schematic view of another preferred embodiment of the first heat sink in the computing host according to the present application;
FIG. 12 is a schematic diagram showing the temperature when computing chips adjacent to an air inlet and computing chips adjacent to an air outlet in a chip region are disposed at different angles at a flow guiding surface during operation of the computing host according to the present application.

In the figures:
10 Housing; 11 Air inlet; 12 Air outlet; 13 Hollowed structure; 14 Insertion groove; 15 Reinforcing rib;
20 Supercomputing unit; 21 Computing board; 211 Substrate; 2111 Chip region; 2111a First sub-region; 2111b Second sub-region; 2111c Third sub-region; 2112 Extension structure; 212 Computing chip; 22 First heat sink; 221 Heat dissipation panel; 222, Heat dissipation fin; 223 Flow guiding surface; 2231 Starting end; 2232 Terminating end; 224 Thermally conductive strip; 23 Second heat sink; 231 Excess portion; 24 Positioning post; 25 Positioning hole; 26 Locking member; 27 Extension spring; 28 Seal;
30 locking screw.

### DETAILED DESCRIPTION OF EMBODIMENTS

The present application will be described based on embodiments, but the present application is not only limited to these embodiments. In the following detailed depictions of the present application, some specific details are presented in detail. In order to avoid confusing the spirit of the present application, well-known methods, processes, procedures and elements are not described in detail.

In addition, those having ordinary skill in the art should appreciate that the figures are provided herein for illustrative purposes and are not necessarily drawn to scale.

Unless the context clearly requires otherwise, words such as "comprise" and "contain" throughout in the whole description and the claim set should be understood as having the meaning of containing rather than exclusive or exhaustive, i.e., as having the meaning of "including but not limited to".

In the description of the present application, it is to be understood that the terms "first", "second" etc. are used for descriptive purposes only and are not to be understood as indicating or implying relative importance. In addition, in the description of the present application, the meaning of "a plurality of" means two or more unless otherwise specified.

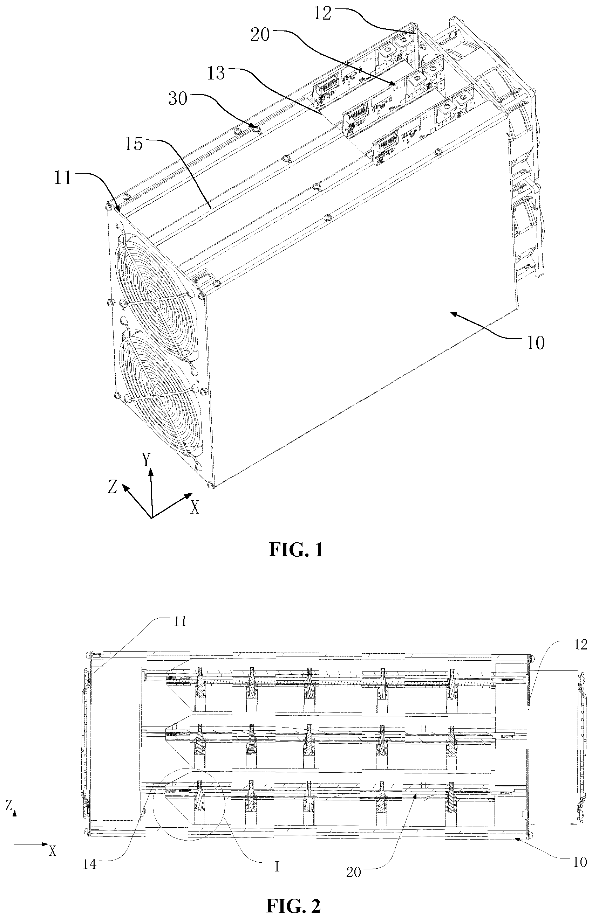

For ease of description, a Cartesian coordinate system is established by taking a depth direction of a housing in a computing host as a first direction X, a height direction as a second direction Y, and a width direction as a third direction Z, as shown in FIG. 1; it should be appreciated that the setting of the coordinate system is only intended for ease of description and not intended to impose any specific limitations on a use state of the computing host, and that a corresponding direction may be determined according to to the state of the computing host while the computing host is used or placed.

The present application provides a computing host for processing data, information, etc., e.g., for processing data and information in a server. Referring to FIG. 1 to FIG. 12, the computing host comprises a housing 10 and a supercomputing unit 20, the housing 10 having an air inlet 11 and an air outlet 12 which are disposed opposite to each other. Specifically, the housing 10 may be a rectangular parallelepiped structure or a quasi-rectangular parallelepiped structure, the air inlet 11 and air outlet 12 are disposed on both end faces of the housing 10, respectively, i.e., the air inlet 11 is disposed on the first end face of the housing 10, the air outlet 12 is disposed on the second end face of the housing 10, and the air inlet 11 and the air outlet 12 are disposed opposite to each other in the first direction X so that the air inlet 11, an inner cavity of the housing 10 and the air outlet 12 form an airflow channel, and the airflow is blown out from the air inlet 11 through the inner cavity of the housing 10 out of the air outlet 12.

The supercomputing unit 20 is mounted in the housing 10 and located between the air inlet 11 and the air outlet 12. The supercomputing unit 20 comprises a first heat sink 22, a computing board 21 and a second heat sink 23 disposed in sequence, i.e., the first heat sink 22, the computing board 21 and the second heat sink 23 assume a sandwich-like structure and are disposed in sequence in the third direction Z. The computing board 21 comprises a substrate 211 and a plurality of computing chips 212. The substrate 211 has two opposite surfaces, namely, a first surface and a second surface, wherein the first surface is provided with a chip region 2111, and the plurality of computing chips 212 are disposed at intervals in the chip region 2111 in the first direction X in which the air inlet 11 and the air outlet 12 are opposite to each other. The first heat sink 22 and the second heat sink 23 both comprise a heat dissipation panel 221 and a plurality of heat dissipation fins 222. The plurality of heat dissipation fins 222 are disposed on a first surface of the heat dissipation panel 221, and extend in the first direction X, i.e., the heat dissipation panel 222 has a first surface and a second surface opposite in a thickness direction thereof (also the thickness direction of the substrate 211), and the heat dissipation fins 222 are disposed on the same surface, namely, the first surface.

The first heat sink 22 and the second heat sink 23 both have a flow guiding surface 223 at a portion close to the air inlet 11, the flow guiding surface 223 is an inclined surface inclined with respect to the second surface of the heat dissipation panel 221, one end of the inclined surface away from the air inlet 11 is inclined in a direction away from the second surface of the heat dissipation panel 221 as compared with the other end of the inclined surface, and the inclined surface extends at least from an outer side surface of the heat dissipation fins 222 away from the heat dissipation panel 221 to a side close to the heat dissipation panel 221; with reference to FIG. 2 through FIG. 9, the flow guiding surface 223 is a windward surface of the heat sinks, is located at one side of the heat sinks (comprising the first heat sink 22 and the second heat sink 23) away from the air outlet 12 and the computing board 21, and gets through the whole heat dissipation fins 222 in the thickness direction of the heat dissipation panel 221. One end of the flow guiding surface 223 located upstream in the air flow direction may be taken as a starting end 2231 (namely, the end close to the air inlet 11) and the other end located downstream in the air flow direction may be taken as a terminating end 2232 (namely, the end away from the air inlet 11). As such, the starting end 2231 of the flow guiding surface 223 is located at the end face of the heat sink facing towards the air inlet 11, and the terminating end 2232 is located on the side of the heat dissipation fins 222 facing away from the heat dissipation panel 221. Specifically, the starting end 2231 is located at least at an edge of the heat dissipation fins 222 close to the heat dissipation panel 221, and the terminating end 2232 is located at an edge of the heat dissipation fins 222 facing away from the heat dissipation panel 221, i.e., all the heat dissipation fins 222 form the flow guiding surface 223 in the third direction Z.

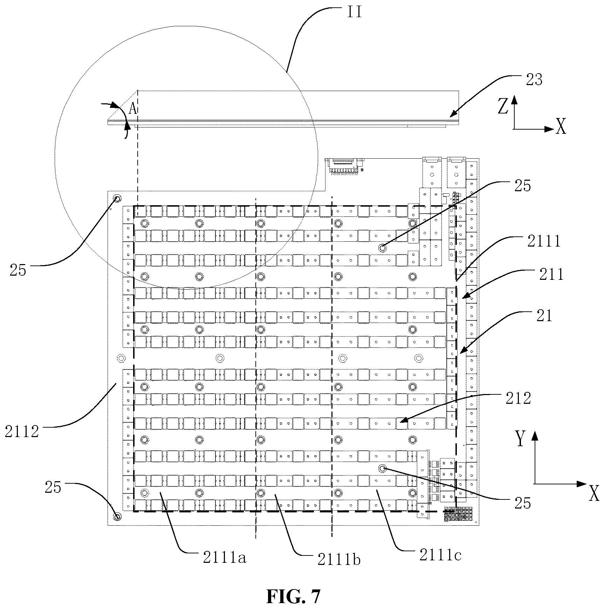

When the first heat sink 22 and the second heat sink 23 are assembled with the computing board 21, the second surfaces of respective heat dissipation panels 221 of the first heat sink 22 and the second heat sink 23 face towards the substrate 211, that is, the surfaces of the respective heat sinks facing away from the heat dissipation fins 223 face towards the computing board 21. Furthermore, the flow guiding surface 223 is at least partially located on the outer side of the chip region 2111 close to the air inlet 11 in the first direction X; referring to FIG. 7, in order to better show the positional relationship between the flow guiding surface 223 and the chip region 2111 of the computing board 21, the first heat sink 22 is shown in a view as viewed in the second direction Y, and the computing board 21 is shown in a view as viewed in the thickness direction thereof (i.e., the third direction Z). In the figure, the end face of the heat sink is closer to the air inlet 11 than the chip region 2111, and the flow guiding surface 223 extends beyond the chip region 2111, i.e., the starting end 2231 of the flow guiding surface 223 is located on the outer side of the chip region 2111 close to the air inlet 11.

In the computing host according to the present application, in a first aspect, the first heat sink 22 and the second heat sink 23 are respectively disposed on both sides of the computing board 21, and the inclined air guiding surface 223 is disposed on each of the heat sinks, so that the flow guiding surface 223 is disposed on the entire heat dissipation fin 222 at least in the thickness direction of the computing board 21, and the flow guiding surface 223 extends beyond the computing chip 212 on the side close to the air inlet 11. As such, the area of the end face of each heat sink on the side close to the air inlet 11 is reduced, so that when the air flow contacts the heat sink, the blocking of the end face against foreign matter such as dust is reduced, the foreign matter such as dust can flow more easily along with the airflow towards the air outlet 12, and then be carried out of the housing 10; meanwhile, the inclined flow guiding surface 223 can guide the airflow so that foreign matter such as dust flows along the flow guiding surface 223 toward the air outlet 12 more easily, thereby further reducing the possibility of foreign matter such as dust being deposited on the end face of each heat sink. It can be seen that the supercomputing host according to the present application greatly reduces the deposition of foreign matter such as dust on the end faces of the heat sinks, so that the heat sinks can still keep the airflow channel smooth even though after use in a long period of time, thereby improving the heat radiation performance of the heat sinks and enabling the whole supercomputing unit 20 to maintain an excellent performance. In a second aspect, since the flow guiding surface 223 of the present application extends at least partially beyond the chip region 2111, the flow guiding surface 223 is provided without substantially reducing the heat dissipation area of the heat sink above the computing chips 212, and can also increase the heat dissipation area on the side of the air intake end, thereby better improving the heat dissipation performance of the whole heat sink, so that the whole computing host can always be in an ideal state. In a third aspect, such a heat sink with the inclined flow guiding surface 223 can also reduce the system impedance, the turbulence is reduced in a way that the airflow is guided by the flow guiding surface 223, and thus the noise is reduced. As compared with the high-frequency harsh noise generated by the heat sink whose windward surface is wholly at a right angle to the second surface of the heat dissipation panel, the heat sink of the present application has a reduced noise frequency due to the reduced turbulence, so that the noise effect of the entire computing host and the server can be improved, and the comfort of human hearing can be enhanced. Furthermore, the flow guiding surface 223 of the present application employs the inclined plane, so that the whole heat sink can be processed more easily.

The housing 10 may be provided with an air ingress fan at the air inlet 11, or with an air egress fan at the air outlet 12, or provided with the air ingress fan and the air egress fan simultaneously so that the air inlet 11, the inner cavity of the housing 10 and the air outlet 12 form the airflow channel, as shown in FIG. 1 and FIG. 2. Furthermore, the housing 10 may also be provided with a grille at the air inlet 11 and air outlet 12 to reduce foreign matter such as dust entering the airflow channel and further reduce the probability that the foreign matter such as dust is deposited on the computing chips 212.

The plurality of computing chips 212 may be arranged in a plurality of chip sets in the first direction X on the substrate 212, each chip set comprising a plurality of computing chips 212 arranged in the second direction Y. The substrate 211 may be provided with the chip region 2111 only, whereupon the heat sink necessarily extends beyond the computing board 21 on the side adjacent to the air inlet 11. Meanwhile the substrate 211 may also be provided with the chip region 2111 and a bare board region (e.g., an extension structure 2112 describer later). The bare board region may be located at an edge region of the substrate 211 close to the air inlet 11, the chip region 2111 may be located on a side of the bare board region away from the air inlet 11, i.e., the bare board region and the chip region 2111 are disposed in the first direction X, and the bare board region is closer to the air inlet 11 than the chip region 2111. At this time, on the side close to the air inlet 11, the heat sink and the computing board 21 may be disposed flush or not flush with each other. In the embodiment, the plurality of computing chips 212 are all disposed in the chip region 2111, and no computing chips 212 are disposed on the bare board region. It may be appreciated that the substrate 211 is further provided with other elements such as other chips, wirings, interface terminals etc. These elements may be partially disposed in the chip region 2111 and partially disposed in the bare board region, or may be all disposed in the bare board region. In other embodiments, the bare board region may also be disposed on the substrate 211 on other sides of the chip region 2111, for example, the bare board region may also be disposed on a side of the chip region 2111 close to the air outlet 12, or the bare board region may be disposed outside two opposite sides of the chip region 2111 in the second direction Y, that is to say, one or more bare board regions may be disposed.

Furthermore, the chip region 211 is divided into a plurality of sub-regions in the first direction X, and each sub-region comprises at least two computing chips 212 arranged in the first direction X; as shown in FIG. 7, the figure shows an embodiment comprising three sub-regions, namely, a first sub-region 2111a, a second sub-region 2111b and a third sub-region 2111c. The number of sub-regions may be specifically set in conjunction with the requirements for the heat dissipation effect. If a spacing between two adjacent computing chips 212 in each sub-region is taken as a sub-region spacing, the sub-region spacing of the sub-regions in the first direction X gradually increases. For example, if, the sub-region spacing of the sub-region located downstream (i.e., close to the air outlet 12) in two adjacent sub-regions is twice that of the sub-region located upstream (i.e., close to the air inlet 11), the number of computing chips 212 corresponding to the heat sink in the same area reduces in the first direction X, i.e., the area of the heat sink corresponding to the same computing chip 212 increases in the first direction X. Therefore, the temperatures of the computing chips 212 in the first direction can be further balanced. As for the same sub-region, the spacing between two adjacent computing chips 212 in the first direction X may be equal, or may gradually increases in the first direction X.

In the first heat sink 22 and the second heat sink 23, the heat dissipation fins 222 are disposed on the entire heat dissipation panel 221 in the first direction X, that is, the heat dissipation fins 222 extend from the edge of the heat dissipation panel 221 close to the air inlet 11 to the edge close to the air outlet 12 in the first direction X. In each heat sink, a distance between two adjacent heat dissipation fins 222 is in a range of 1 mm to 3 mm, such as 1 mm, 1.5 mm, 2 mm, 2.5 mm or 3 mm, preferably 2 mm. With the setting of such a spacing being employed, not only more heat dissipation fins 222 can be disposed to increase the heat dissipation area, but also foreign matter such as dust entering between adjacent heat dissipation fins 222 can be smoothly blown out of the whole heat sink, to prevent foreign matter such as dust from being choked and seized between adjacent heat dissipation fins 222 and blocking the airflow channel, thereby ensuring the smoothness of the air flow.

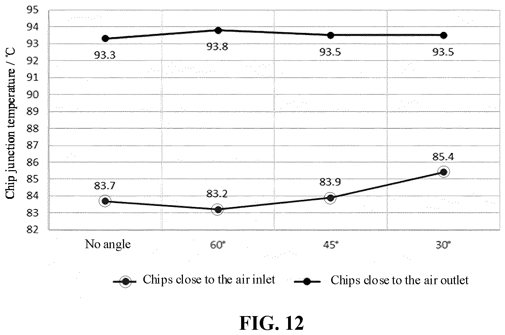

With reference again to FIG. 7, an angle A between the flow guiding surface 223 and the second surface of the heat dissipation panel 221 is an acute angle. The angle A is preferably in a range of 30° to 60°, such as 30°, 35°, 40°, 42°, 45°, 48°, 50°, 55°, or 60°, etc. Furthermore, the angle is in a range of 40° to 50°, and more preferably 45°. Selection and use of the angle in the above range can avoid that a too large angle has a greater blocking effect on foreign matter such as dust and the foreign matter is not blown away easily, and can also avoid that a too small angle causes a limited increase of the heat dissipation area and affects the heat dissipation effect. Referring to FIG. 12, the figure shows the temperature of the computing chips 212 close to the air inlet 11 and the computing chips 212 close to the air outlet 12 on the chip region 2111 when a flow guiding surface is not provided (i.e., the end face of the heat sink away from the air inlet 11 is made flush with the chip region 2111, and the end face is a plane perpendicular to the second surface of the heat dissipation panel 221) and the angle of the flow guiding surface 223 is 60°, 45° and 30°, respectively. It can be seen from the figure that with angle in the range being employed, a maximum temperature difference between the computing chips 212 close to the air inlet 11 and the computing chips 212 close to the air outlet 12 does not exceed 10.6°C, and the temperature of the computing chips 212 close to the air inlet 11 is not higher than 86°C, and the temperature of the computing chips 212 close to the air outlet 12 is not higher than 94°C, and the forgoing temperatures are all within the temperature range of the computing chips for normal operation; furthermore, in a case where the angle is 45° and in a case where the flow guiding surface is not disposed, the temperature values of the computing chips 212 close to the air inlet 11 are equivalent in the two cases, the temperature values of the computing chips 212 close to the air outlet 12 are equivalent in the two cases, and the temperature differences between the computing chips 212 close to the air inlet 11 and the computing chips 212 close to the air outlet 12 are also substantially equivalent in the two cases, without a significant change. Furthermore, the effect of blocking foreign matter such as dust is also better when the angle is 45°.

In each of the above embodiments, the flow guiding surface 223 is located at least partially on the side of the chip region 2111 adjacent the air inlet 11, that is, the heat sink extends beyond the side of the chip region 2111 adjacent the air inlet 11, as shown in FIG. 7 through FIG. 9. Preferably, a size of extension of the heat sink beyond the chip region 2111 is in a range of 15 cm to 22 cm, such as 15 cm, 16 cm, 17 cm, 18 cm, 19 cm, 20 cm, 21 cm or 22 cm, etc. Further preferably, the size of extension of the heat sink beyond the chip region 2111 is 20 cm. Employing this range of size can better compensate for the heat dissipation area lost due to the arrangement of the flow guiding surface 223, thereby better improving the heat dissipation effect of the entire heat sink. The portion of the heat sink extending beyond the chip region 2111 may only comprise part of a variable-cross-section structure corresponding to the heat sink where the flow guiding surface 223 is located, and may also comprise the whole variable-cross-section structure, or may comprise the variable-cross-section structure corresponding to the heat sink where the flow guiding surface is located and other constant-cross-section structures on the heat sink, that is to say, the heat sink comprises a variable-cross-section structure and a constant-cross-section structure in the first direction X, the variable-cross-section structure is located at the side close to the air inlet 11; a cross-section of the variable-cross-section structure perpendicular to the first direction X gradually increases in the air flow direction; a cross section of the constant-cross-section structure perpendicular to the first direction X is constant in the air flow direction. The flow guiding surface 223 is formed on the outer side of the variable-cross-section structure away from the second surface of the heat dissipation panel 221, i.e., the flow guiding surface 223 is disposed on the variable-cross-section structure. It is possible that only a portion of the variable-cross-section structure extends beyond the chip region 2111 (namely, the variable-cross-section structure only partially extends beyond the chip region 2111, and the remaining portion is located above the chip region 2111), or all of the variable-cross-section structure extends beyond the chip region 2111, or all of the variable-cross-section structure and a portion of the constant-cross-section structure extend beyond the chip region 2111 together.

The end of the flow guiding surface 223 close to the air inlet may all be located on the heat dissipation fins 222, and the end of the flow guiding surface 223 close to the air inlet may also be located on the end face of the heat dissipation panel 221 close to the air inlet 11, that is to say, the starting end 2231 of the flow guiding surface may be located on the heat dissipation fins 222, and may also be located on the heat dissipation panel 221.

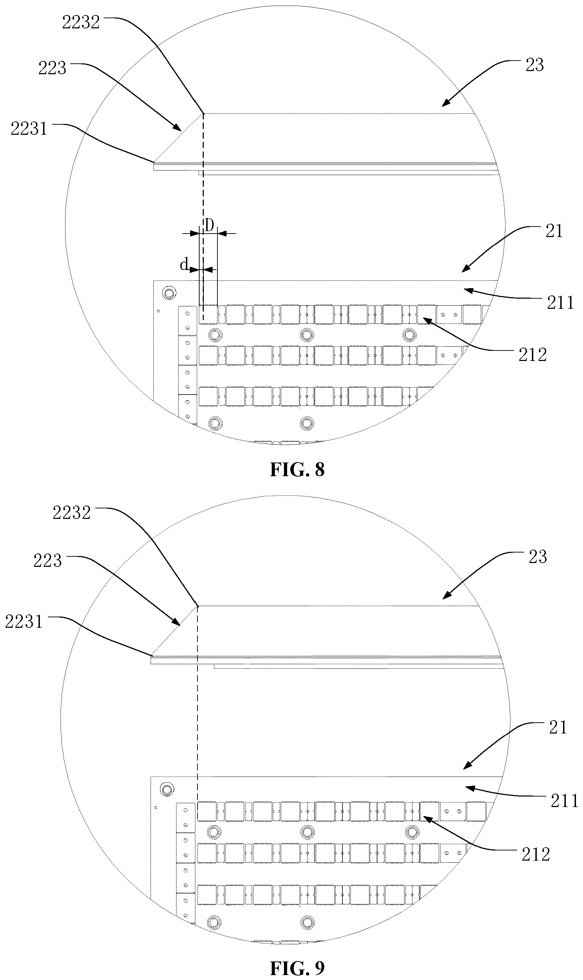

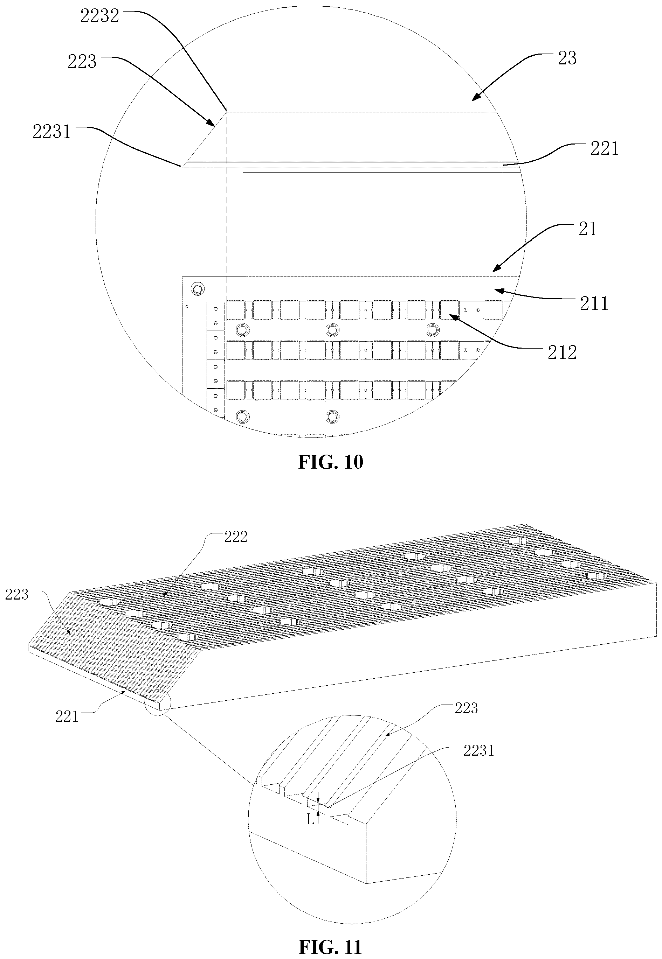

In one embodiment, the starting end 2231 of the flow guiding surface 223 is located entirely on the heat dissipating fins 222, i.e., the flow guiding surface 223 is formed only on the heat dissipating fins 222. Specifically, the end (namely, the starting end 2231) of the flow guiding surface 223 close to the air inlet is located on the end face of the heat dissipation fins 222 close to the air inlet, and a distance may or may not be left between the end and the first surface of the heat dissipation panel 221. As shown in FIG. 11, the distance may be less than or equal to 2 mm, i.e., L≤2 mm in the figure, such as 2 mm, 1.8 mm, 1.5 mm, 1.2 mm, 1 mm, 0.8 mm, 0.5 mm, 0.3 mm or 0 mm, and preferably the distance is 0.5 mm. With such a structure, while the deposition of foreign matter such as dust on the end face of the heat sink can be reduced, the heat dissipation area can be appropriately increased, and particularly, the commonality in processing the heat sink can be increased. For example, in a solution in which a heat conduction plate (described in detail below) is provided, particularly when a heat pipe is mounted on the heat conduction plate, the selection and use of such a heat sink can help select the same processing technology. Specifically, the flow guiding surface 223 may be formed by cutting a rectangular parallelepiped heat sink, whereupon the cutting procedure may employ the same process, thereby saving the processing cost. Certainly, the end (namely, the starting end 2231) of the flow guiding surface 223 close to the air inlet may also be located at a position where the heat dissipation fins 222 are connected with the heat dissipation panel 221, as shown in FIG. 8 and FIG. 9. At this time, the above-mentioned distance L is equal to 0.

In another embodiment, the starting end 2231 of the flow guiding surface 223 may also be located on the end face of the heat dissipation panel 221 close to the air inlet 11, i.e., the flow guiding surface 223 is formed on the heat dissipation fins 222 and the heat dissipation panel 221, the starting end thereof is located between the first surface and the second surface of the heat dissipation panel 221, or directly located on the second surface. As shown in FIG. 10, the starting end 2231 of the flow guiding surface 223 is located on the second surface of the heat dissipation panel 221, and the flow guiding surface 223 intersects with the second surface of the heat dissipation panel 221.With the starting end 2231 of the flow guiding surface 223 being disposed on the end face of the heat dissipation panel 221, the area of the end face of the entire heat sink can be further reduced, i.e., as large an area as possible of the windward surface of the entire heat sink is taken as the flow guiding surface 223 to better reduce the blocking of foreign matter such as dust by the end face so that the foreign matter such as dust can be smoothly blown out through the air outlet 12, thereby improving the overall heat radiation performance.

Preferably, the end of the flow guiding surface 223 close to the air inlet 11 extends to the second surface of the heat dissipation panel 221, that is to say, the starting end 2231 of the flow guiding surface is located at the second surface of the heat dissipation panel 221, and the flow guiding surface 223 intersects with the second surface of the heat dissipation panel 221; Certainly, the embodiment comprises a structure in which the flow guiding surface 223 and the second surface of the heat dissipation panel 223 transition in an edgeless manner. In this way, the windward surface of the whole heat sink is allowed to be the flow guiding surface, thereby further reducing the deposition of foreign matter such as dust on the end face of the heat sink, improving the heat dissipation performance durability of the whole heat sink, and substantially enhancing the performance stability of the whole supercomputing unit particularly in combination with the above arrangement with the angle and the above arrangement of the spacing between the heat dissipation fins 222. With regard to the relative positions of the terminating end 2232 of the flow guiding surface 223 and the chip region 2111, in one embodiment, the terminating end 2232 is located on a side of the chip region 2111 close to the air inlet 11, i.e., the flow guiding surface 223 is located on an upstream side of the chip region 2111, and a distance is left between the terminating end 2232 and the edge of the chip region 2111 close to the air inlet 11, that is to say, the flow guiding surface 223 is projected in the thickness direction (i.e., the third direction Z) of the substrate 211. There is no overlapping region between the projection of the flow guiding surface 223 and the computing chip 212 closest to the air inlet 11, and a distance is left between two adjacent edges of the projection of the flow guiding surface 223 and the computing chip 212 closest to the air inlet 11.

In another embodiment, the terminating end 2232 of the flow guiding surface 223 may also extend into the chip region 2111, as shown in FIG. 8, i.e., the terminating end 2232 extends into the region of the chip region 2111 where the first computing chip 212 is located. That is, the flow guiding surface 223 is projected in the thickness direction (i.e., the third direction Z) of the substrate 211; the projection of the flow guiding surface 223 and the computing chip 212 closest to the air inlet 11 have an overlapping region, and the size of the overlapping region in the first direction X is less than or equal to 1/4 of the size of the computing chip 212. Referring to FIG. 7, as viewed in the thickness direction of the substrate 211, the flow guiding surface 223 and the chip region 2111 have the overlapping region at most at the first computing chip 212, and the overlapping region has a size in the first direction X less than or equal to 1/4 of the size of the computing chip 212 in the first direction X, i.e., the size d in the figure is less than or equal to 1/4 of the size D of the computing chip 212 , e.g., d is 0.25D, 0.2D, 0.1D, 0.05D or less, e.g., d is directly 0 (as shown in FIG. 9), i.e., the terminating end 2232 of the flow guiding surface 223 is flush with the first edge of the first computing chip 212 . By setting the distance that the flow guiding surface 223 extends into the first computing chip 212, it is possible to reduce the possibility of foreign matter such as dust being deposited on the end face of the heat sink and increase the heat dissipation area of the whole heat sink, and meanwhile it is also possible to balance the temperatures of the computing chips 212 in the first direction X so that the temperatures of the computing chips 212 in the first direction X are substantially uniform, especially to reduce the temperature difference between the computing chips 212 located most upstream and most downstream as much as possible, thereby better improving the performance of the whole computing board 21 and making the service life of the computing chips 212 as consistent as possible. The first computing chip 212 in the chip region 2111 is the computing chip 212 located most upstream in the chip region 2111 in the air flow direction, namely, the computing chip 212 closest to the air inlet 11 in the chip region 2111, and may be a row of computing chips 212; a first edge of the computing chip 212 refers to the edge of the computing chip 212 located upstream, and is also the edge close to the air inlet 11.

More preferably, the terminating end 2232 of the flow guiding surface 223 is flush with the edge of the chip area 2111 close to the air inlet 11. In the projection of the substrate 211 in the thickness direction (namely, the third direction Z), the terminating end 2232 of the flow guiding surface 223 away from the air inlet 11 coincides with the close-to-air inlet 11 first edge of the computing chip 212 closest to the air inlet 11, i.e., the terminating end 2232 of the flow guiding surface 223 is flush with the first edge of the first computing chip 212, and the above-mentioned d is equal to 0, as shown in FIG. 9. With such a structure, the temperatures of the computing chips 212 in the first direction X can be better balanced, so that the temperatures of the computing chips 212 are as balanced as possible.

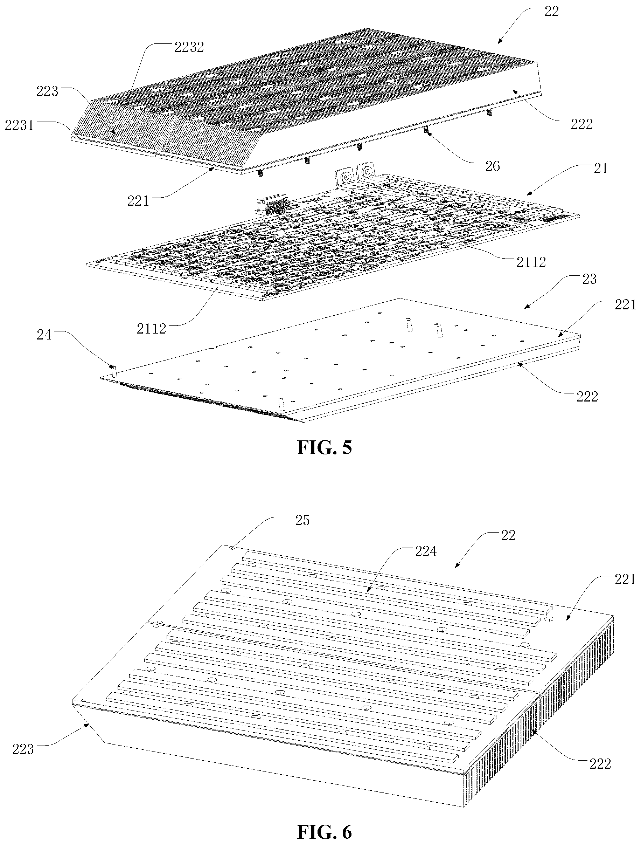

It needs to be appreciated that FIG. 6-FIG. 9 only show the structure of the first heat sink 22, and the structure of the second heat sink 23 may be the same as that of the first heat sink 22.

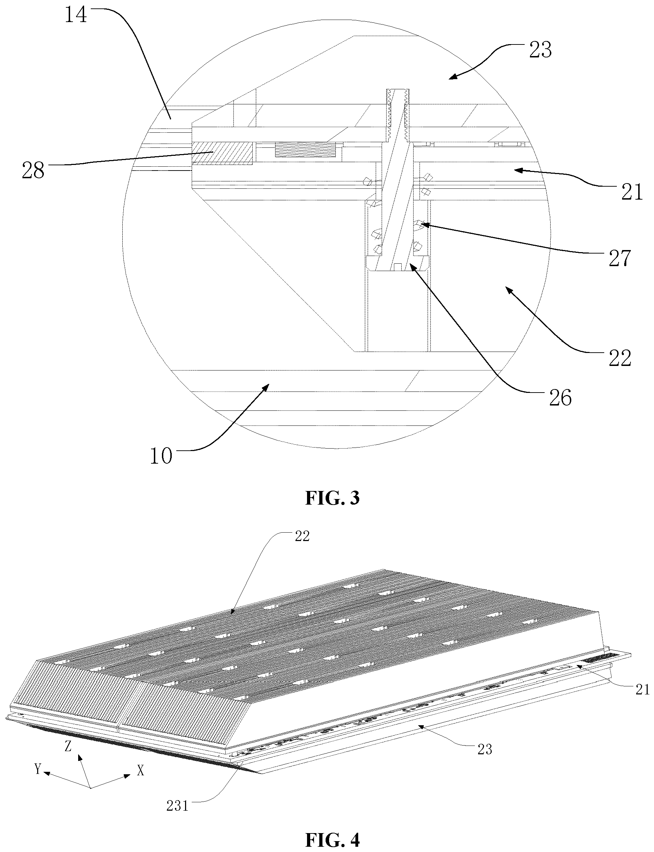

In order to better improve the effect of the heat sink of conducting the heat from the computing board 21, both the first heat sink 22 and the second heat sink 23 are fitted against the computing board 10; furthermore, a thermally conductive strip 224 is disposed at least on the heat sink fitted against the computing chips 212; as shown in FIG. 6, the thermally conductive strip 224 is located on the side of the heat dissipation panel 221 close to the substrate 211, and the thermally conductive strip 224 protrudes from the second surface of the heat dissipation panel 221 and extends in the first direction X. As shown in FIG. 4, an example is taken in which the first heat sink 22 is located on the side of the substrate 211 where the computing chip 212 is disposed, namely, the first heat sink 22 is fitted against the computing chip 212, and the second heat sink 23 is fitted against the side of the substrate 211 facing away from the computing chip 212. In this example, only the first heat sink 22 may be provided with the thermally conductive strip 224, or both the first heat sink 22 and the second heat sink 23 may be provided with the thermally conductive strip 224. In a preferred embodiment, the first heat sink 22 further comprises a thermally conductive strip 224, and the first heat sink 22 is fitted against the computing chips 212 via the thermally conductive strip 224, i.e., the thermally conductive strip 224 is fitted against the computing chips 212. In an embodiment where a plurality of computing chips 212 are arranged in a plurality of chip sets in the second direction Y, the plurality of thermally conductive strips 224 are also disposed in the second direction Y, the plurality of thermally conductive strips 224 are fitted against the plurality of chip sets in a one-to-one correspondence, and one thermally conductive strip 224 is fitted against each computing chip 212 in a corresponding chip set. The processing difficulty of the first heat sink 22 can be reduced by means of the protrusively-disposed thermally conductive strip 224. The area of the computing board 21 is usually large, and the distribution of the plurality of computing chips 212 occupies most of the area of the substrate 211; in order to conduct the heat of each computing chip 211 to the external as soon as possible, it is preferable that the first heat sink 22 is fitted against each computing chip 212; however, such a large area imposes a too high processing precision requirement for the side of the first heat sink 22 facing towards the computing board 21, and it is even impossible to ensure that each computing chip 212 can be fitted after final assembly. However, such a protrusively-disposed thermally conductive strip 224 has a relatively small area, and the flatness thereof can be easily ensured, so the thermally conductive strip 224 can substantially reduce the difficulty in processing the heat sink, ensure the fit with the computing chips after assembly, and improve the operation performance of the whole supercomputing unit 20 while reducing the deposition of the foreign matter such as dust. Specifically, the thermally conductive strips 224 may be directly formed integrally with the heat dissipation panel 221 and the heat dissipation fins 222, or may be assembled together after being machined separately. In one embodiment, the first heat sink 22 may further comprise a heat conduction plate, wherein the heat conduction plate is fitted against the heat dissipation panel 221, and the thermally conductive strip 224 is disposed on a side of the heat conduction plate facing away from the heat dissipation panel 221; use of such a structure can facilitate machining and facilitate assembling the thermally conductive strip 224 with the heat dissipation panel 221. The thermally conductive strip 224 may have the same size as the entire chip region 2111 in the first direction X, or both ends of the thermally conductive strip 224 may extend beyond the chip region 2111 in the first direction X. In a preferred embodiment, considering that the surface of the substrate 211 facing away from the computing chips 212 is substantially flat, the second heat sink 23 may be fitted against the substrate 211 directly through the heat dissipation panel 221, and the thermally conductive strip 224 is not disposed on the surface of the substrate 211 facing away from the heat dissipation fins 222.

Furthermore, a thermal interface material (TIM), i.e., a thermally conductive glue, such as silicone grease, gel, etc. is also provided between the thermally conductive strip 224 and the computing chips 212. Although the area of the thermally conductive strip 224 is already substantially reduced relative to the entire heat sink, during actual processing and assembling there is still a small gap between the thermally conductive strip 224 and the computing chips 212 after assembly, and the thermal conduction efficiency and thermal conduction effect of the computing chips 212 and thermally conductive strip 224 can be better increased by filling the thermal interface material. The smaller the flatness of the surface of the thermally conductive strip 224 (mainly referring to the surface facing towards the computing chips 212) is, the smaller the thickness of the filled thermal interface material is, so that the heat of the computing chips 212 can be conducted out more easily.

In order to improve the heat conduction effect, in an embodiment where the heat conduction plate is provided, an accommodating groove may also be provided on a surface of the heat conduction plate facing towards the heat dissipation panel 221, a heat pipe may be provided in the accommodating groove, and a phase change material may be filled in the interior of the heat pipe so as to transfer the heat of the thermally conductive strip and the heat conduction plate to the heat dissipation panel 221 as soon as possible through a state change of the phase change material. Furthermore, in order to improve the heat transfer performance and efficiency of the heat pipe and other regions on the heat conduction plate with the heat dissipation panel, a solder, such as a solder paste, may be filled between the heat pipe and the accommodating groove of the heat conduction plate, between the heat pipe and the heat dissipation panel 221, and between other regions on the heat conduction plate and the heat dissipation panel 221. Specifically, the heat pipe, the heat conduction plate and the heat dissipation panel 221 may be welded together by the solder, thereby improving the overall heat dissipation effect. Of course, it is also possible to fill the thermal interface material at only one of the positions. Preferably, the solder is filled at least between the heat pipe and the heat conduction plate, and between the heat pipe and the heat dissipation panel 221. Further preferably, the accommodating groove may be disposed corresponding to the thermally conductive strip 224; in a set of accommodating groove and thermally conductive strip 224 corresponding to each other, it is feasible that both ends of the accommodating groove extend beyond the thermally conductive strip 224, and accordingly, the heat pipe also extends beyond the thermally conductive strip 224 in the length direction.

In an embodiment where the first heat sink 22 is located on the side of the substrate 211 where the computing chips 212 are disposed, only one first heat sink 22 may be disposed on the same side of the same substrate 211, and the first heat sink 22 covers all computing chips 212, i.e., the first heat sink 22 is fitted against all the computing chips 212 simultaneously. In a preferred embodiment, a plurality of first heat sinks 22 are provided on the same side of the same substrate 211 in the second direction Y, and the plurality of first heat sinks 22 cover the plurality of computing chips 212 in the second direction Y, for example, two, three or more first heat sinks 22 are provided. FIG. 4 shows a structure provided with two first heat sinks 22. Each of these first heat sinks 22 covers part of the computing chips 212. As such, the requirement for the area of each first heat sink 22 in contact with the computing chips 212 is smaller, thereby reducing the difficulty in processing the first heat sink 22, enabling the first heat sink 22 to better fitted against the computing chips 212 and further improving the heat dissipation efficiency of the computing chips 212. Similarly, only one second heat sink 23 or two, three or more second heat sinks 23 may be provided on the side of the substrate 211 facing away from the computing chips 212. Preferably, two first heat sinks 22 are disposed on the side of the same substrate 211 on which the computing chips 212 are disposed, and one second heat sink 23 is disposed on the other side. The setting of two first heat sink 22 can not only reduce the difficulty in processing the first heat sinks 22 and ensure the fitting area of the first heat sinks 22 and the computing chips 212, but also reduce the time spent in assembling the first heat sinks 22 with the computing board 21.

In the embodiment in which the first heat sink 22 is located on the side of the substrate 211 where the computing chips 212 are provided, and the second heat sink 23 is located on the side of the substrate 211 facing away from the computing chips 212, the size of the first heat sink 22 is greater than that of the second heat sink 23 in the thickness direction of the substrate 211, i.e., the third direction Z, so as to further increase the effect of the first heat sink 22 dissipating heat from the computing chips 212. Preferably, the size of the first heat sink 22 is twice that of the second heat sink 23 in the thickness direction of the substrate 211, to better enhance the heat dissipation effect of the whole supercomputing unit 20. In some embodiments, the size of the first heat sink 22 is equal to that of the second heat sink 23 in the thickness direction of the substrate 211. The sizes may be specifically selected in conjunction with the distribution of the computing chips 212.

In all the above embodiments, the heat sink may be flush with the end face of the computing board 21 on the side close to the air inlet 11. At this time, the substrate 211 further comprises an extension structure 2112 located on the side of the chip region 2111 close to the air inlet 11. The extension structure 2112 may form one bare board region as previously described, and the extension structure 2112 is flush with the end face of the heat sink 22, and specifically flush with the starting ends of the flow guiding surfaces 223 in the first heat sink 22 and the second heat sink 23. The computing board 21 can extend beyond the heat sink on the side close to the air outlet 12, and specifically, the substrate 211 extends beyond the heat sink. That is to say, the substrate 211 further comprises an extension structure 2112 located on the side of the chip region 2111 close to the air outlet 12, the extension structure 2112 extends beyond the heat sink and specifically extends beyond the end faces of the first heat sink 22 and the second heat sink 23 close to the air outlet 12, so as to facilitate arrangement of the circuit on the computing board 21 and facilitate the arrangement of interfaces, etc. The computing board 21 may also perform line connection with other devices or modules via the extension structure 2112. In summary, the arrangement that the heat sinks are flush with the computing board 21 on the upstream side and the computing board 21 extends beyond the heat sinks on the downstream side can not only minimize the resistance to the air flow on the upstream side, allow the air flow to flow along the channels between the heat dissipation fins 222 and the flow guiding surface 223 as much as possible, thereby enabling foreign matter such as dust to be blown out of the whole supercomputing unit 20 better, but also make the structure of the whole supercomputing unit 20 more compact and regular, to facilitate the spatial arrangement of the integrated units in the server, and to facilitate the connection of the computing board 21 with other components.

Furthermore, a part of the top wall of the housing 10 close to the air outlet 12 in the second direction Y is a hollowed structure 13. As shown in FIG. 1, the computing board 21 at least partially extends beyond the first heat sink 22 and the second heat sink 23 on the side close to the top, and extends beyond the hollowed structure 13 to facilitate connection with other devices or modules outside the housing 10 via the computing board 21.

In order to improve the positioning accuracy of assembly, especially the fitting accuracy of the computing chips 211 and the heat sinks, three parts, i.e., the first heat sink 22, the computing board 21 and the second heat sink 23 in the supercomputing unit 20 may be provided with a positioning structure. The positioning structure may be provided between two adjacent ones of the three parts, for example, any two adjacent ones are positioned. In a preferred embodiment, the three parts are positioned by the same positioning structure; specifically, the positioning structure may comprise a positioning post and a positioning hole, i.e., one of the three parts is provided with a positioning post, and the remaining two parts are provided with a positioning hole corresponding to the positioning post. Certainly, a plurality of sets of corresponding positioning posts and positioning holes may be provided, and respective positioning posts are inserted into the positioning holes so as to position the first heat sink 22, the computing board 21 and the second heat sink 23. Particularly in an embodiment where the thermally conductive strip 224 is provided, the positioning structure can improve the fitting degree of the thermally conductive strip 224 and the computing chip 212 and thereby enhance the heat dissipation effect of the whole supercomputing unit. Preferably, in the embodiment where the first heat sink 22 is located at the side of the substrate 211 where the computing chips 212 are disposed, as shown in FIG. 5, the second heat sink 23 is provided with a positioning post 24 facing towards the substrate 211; positioning holes 25 corresponding to the positioning posts are provided on both the substrate 211 and the first heat sink 22, and respective positioning posts 24 are inserted in and fitted with the respective positioning holes 25. With this structure, not only the assembly efficiency can be improved, but also the fitting accuracy of the computing chips 212 and the first heat sink 22 can be increased. Further preferably, the positioning holes 25 on the substrate 211 are distributed on the extension structure 2112 and the chip region 2111, i.e., the extension structure 2112 and the chip region 2111 are both provided with the positioning holes 25, so as to further improve the fitting accuracy of the computing chips 212 and the heat sink. In an embodiment in which a plurality of first heat sinks 22 are provided, each of the first heat sinks 22 is provided with at least two positioning holes 25.

The first heat sink 22, the computing board 21, and the second heat sink 23 may be connected by screw connection or snap-fit connection. In an embodiment in which the connection is performed using screws, a first mounting hole may be provided on the substrate 211, one of the first heat sink 22 and the second heat sink 23 is provided with a second mounting hole corresponding to the first mounting hole, and the other is provided with a locking hole corresponding to the first mounting hole; the supercomputing unit 20 further comprises a locking member 26 which runs through the second mounting hole and the first mounting hole to lock with the locking hole. Preferably, the second mounting hole is a stepped hole; the supercomputing unit 20 further comprises an extension spring 27, and the locking member 26 comprises a screw head and a screw shank, wherein the screw shank runs through the corresponding second mounting hole and the first mounting hole to lock with the locking hole, as shown in FIG. 2 and FIG. 3. Then extension spring 27 is located between the screw head and a stepped surface of the stepped hole, and corresponding first mounting holes, second mounting holes and locking holes may be provided in multiple sets, to increase the reliability of the connection of the components of the supercomputing unit 20, and increase the fitting degree of the heat sink and the computing board 21, and enhance the heat dissipation effect of the whole supercomputing unit 20.

The first mounting holes may be provided between two adjacent chip sets, and the first mounting holes may also be provided in multiple sets in the second direction Y, with each set comprising a plurality of first mounting holes in the first direction X. The first mounting holes may be provided between every two adjacent chip sets, or may be provided between only part of two adjacent chip sets. In a preferred embodiment, each two chip sets are successively provided spaced apart from a set of first mounting holes. Use of such an arrangement between relative positions of the first mounting holes and the computing chips 212 can not only improve the fitting tightness of the computing chips 212 and the heat sink, but also reduce the number of holes provided on the substrate 211, thereby facilitating the layout of other lines on the substrate 211 (since a too large number of holes cause reduction of the space on the substrate 211, which affects the layout of other lines).

In an embodiment where the first heat sink 22 is located on the side of the substrate 211 where the computing chips 212 are disposed, preferably, the second mounting holes are disposed on the first heat sink 22, and the locking holes are disposed on the second heat sink 23; the positioning posts 24 are provided on the second heat sink 23, and the first heat sink 22 is provided with the positioning holes. As such, the pressure for fixing the heat sink can be adjusted by controlling the magnitude of the spring force of the extension spring 27, and meanwhile the uniformity of the pressure received by fixing points of the heat sinks can also be ensured so that the heat sinks and the computing chips 212 can be brought into good contact, thereby improving the heat transfer performance between the computing board 21 and the heat sinks.

Furthermore, considering that there is inevitably a gap between the substrate 211 and the heat sinks, particularly between the substrate 211and the heat sink (e.g., the first heat sink 22) located on the side where the computing chips 212 are located, in order to prevent foreign matter such as dust from being deposited adjacent the computing board 21, particularly the computing chips 212, the supercomputing unit 20 further comprises a seal 28, as shown in FIG. 3. When the computing board 21 has an extension structure 2112 located on the side of the chip region 2111 close to the air inlet 11, the seal 28 may be provided between the heat sinks and the extension structure 2112, particularly the seal 28 may be provided between the first heat sink 22 fitted against the computing chips 211 and the substrate 211; in an embodiment in which the extension structure 2112 is not provided on the side of the chip region 2111 close to the air inlet 11, the seal 28 may be directly provided between the first heat sink 22 and the second heat sink 23 in a region close to the air inlet 11, that is, the seal 28 is located on the upstream side of the computing board 21 in the embodiment.

The supercomputing unit 20 may be mounted to the housing 10 through the first heat sink 22 or a second heat sink 23, specifically in a connection manner such as snap-fit connection, plug-in connection or screw connection. Preferably, an insertion groove 14 may be provided on an inner wall of the housing 10, and the first heat sink 22 or the second heat sink 23 is inserted in the insertion hole 14 for connection. In an embodiment in which the first heat sink 22 is located on the side of the substrate 211 where the computing chips 212 are provided, it is preferable that the supercomputing unit 20 is mounted to the housing 10 via the second heat sink 23 by plug-in connection. Specifically, a top wall and a bottom wall of the housing 10 are provided with the insertion grooves 14, both ends of the second heat sink 23 in the second direction Y extend beyond the computing board 211 and the first heat sink 22. As shown in FIG. 4, the second heat sink 23 is inserted in and connected with the insertion grooves on the housing via the excess portion. In this way, the structure and arrangement manner of the first heat sink 22 will not be affected because the second heat sink 23 is mounted with the housing 10. In an embodiment, opposite insertion grooves on the housing 10 may be provided a plurality of respective sets which each have a different size in the third direction Z from the housing 10. In actual use, different respective sets of insertion grooves may be selected according to the sizes of the first heat sink 22 and second heat sink 23 to mate with the supercomputing unit 20. Furthermore, a through hole may be provided at the insertion groove 14, and a threaded hole may be correspondingly provided at the first heat sink 22 or the second heat sink 23; after the first heat sink 22 or the second heat sink 23 is inserted into the insertion groove 14, the housing 10 is further locked with the first heat sink 22 or the second heat sink 23 by the mating a locking screw 30 with the through hole and the threaded hole. Furthermore, in order to increase the reliability of the connection of the supercomputing unit 20 with the housing 10, reinforcing ribs 15 are provided on the outer side of the top wall of the housing 10, and through holes are provided on the reinforcing ribs 15.

Only one supercomputing unit 20 or a plurality of supercomputing units 20 may be provided in the housing 10. In one embodiment, a plurality of supercomputing units 20, e.g., two, three or more supercomputing units 20, are provided side by side in the thickness direction (namely, the third direction Z) of the substrate 211 in the housing 10. With the plurality of supercomputing units 20 being provided at the same time, the data processing capability of the whole supercomputing host can be improved and the user's experience can be enhanced.

In an embodiment provided with the plurality of supercomputing units 20, the first heat sink 22 of one of two adjacent supercomputing units 20 is adjacent to the second heat sink 23 of the other supercomputing unit 20, and a spacing between the two adjacent supercomputing units 20 is in a range of 2 mm-4 mm, such as 2 mm, 2.2 mm, 2.5 mm, 2.8 mm, 3 mm, 3.2 mm, 3.5 mm, 3.8 mm or 4 mm, and preferably the spacing is 2.8 mm. In this way, the data processing capability of the whole supercomputing host can be increased, and the heat dissipation performance of each supercomputing unit 20 can be improved by the spacing, so that the respective data processing capability of the supercomputing units 20 can be ensured.

The present application further provides a server comprising the supercomputing host according to any of the above embodiments. In addition to the supercomputing host, the server may further comprise a control module and a power supply module which may be respectively disposed at a side and the top of the housing 10, and be electrically connected to the computing board 21.

Those skilled in the art can appreciate that the above-described preferred solutions may be freely combined and superimposed without conflict.

It should be appreciated that the above-described embodiments are merely exemplary rather than limiting, and that various obvious or equivalent modifications to and substitutes for the above-described details made by those skilled in the art without departing from the basic principles of the present application, are all included within the scope of the appended claims of the present application.

## Claims

1. A computing host, comprising a housing and a supercomputing unit, the housing having an air inlet and an air outlet; the supercomputing unit being mounted in the housing and is located between the air inlet and the air outlet, wherein,
the supercomputing unit comprises a first heat sink, a computing board and a second heat sink which are disposed in sequence;
the computing board comprises a substrate and a plurality of computing chips, a chip region is provided on a first surface of the substrate, and the plurality of computing chips are disposed at intervals in the chip region in a first direction in which the air inlet and the air outlet are opposite to each other;
the first heat sink and the second heat sink each comprise a heat dissipation panel and a plurality of heat dissipation fins, the plurality of heat dissipation fins are disposed on a first surface of the heat dissipation panel, and all said heat dissipation fins extend in said first direction;
wherein the first heat sink and the second heat sink are each provided with a flow guiding surface at a portion close to the air inlet, the flow guiding surface is an inclined surface inclined with respect to a second surface of the heat dissipation panel, one end of the inclined surface away from the air inlet is inclined in a direction away from the second surface of the heat dissipation panel as compared with the other end of the inclined surface, and the inclined surface extends at least from an outer side surface of the heat dissipation fins away from the heat dissipation panel to a side close to the heat dissipation panel;
the second surfaces of respective heat dissipation panels of the first heat sink and the second heat sink face towards the substrate, and the flow guiding surface is at least partially located on an outer side of the chip region close to the air inlet in the first direction.

2. The computing host according to claim 1, wherein an angle between the inclined surface and the second surface of the heat dissipation panel is in a range of 30°-60°.

3. The computing host according to claim 1, wherein an angle between the inclined surface and the second surface of the heat dissipation panel is 45°.

4. The computing host according to claim 1, wherein in a projection in the thickness direction of the substrate, a projection of the flow guiding surface and the computing chip closest to the air inlet have an overlapping region, and a size of the overlapping region in the first direction is less than or equal to 1/4 of the size of the computing chip.

5. The computing host according to claim 1, wherein in a projection in the thickness direction of the substrate, a terminating end on the projection of the flow guiding surface away from the air inlet coincides with a first edge of the computing chip closest to the air inlet, and the first edge is an edge of the computing chip close to the air inlet.

6. The computing host according to claim 1, wherein a distance between an end of the flow guiding surface close to the air inlet and the first surface of the heat dissipation panel is less than or equal to 2 mm.

7. The computing host according to claim 1, wherein an end of the flow guiding surface close to the air inlet extends to the second surface of the heat dissipation panel.

8. The computing host according to claim 1, wherein in the first heat sink and the second heat sink, a distance between two said adjacent heat dissipation fins is in a range of 1 mm to 3 mm.

9. The computing host according to claim 1, wherein a size of extension of the heat sink beyond the chip region is in a range of 15 cm to 22 cm.

10. The computing host according to claim 1, wherein the first heat sink is located on a side of the substrate where the computing chips are disposed;
the first heat sink further comprises a thermally conductive strip, the thermally conducive strip is located on a side of the heat dissipation panel close to the substrate, and the thermally conductive strip extends in the first direction; the first heat sink is fitted against the computing chips via the thermally conductive strip.

11. The computing host according to claim 1, wherein a thermal interface material is further provided between the thermally conductive strip and the computing chips.

12. The computing host according to claim 1, wherein the second heat sink is provided with positioning posts facing towards the substrate; positioning holes corresponding to the positioning posts are provided on both the substrate and the first heat sink, and the respective positioning posts are inserted in and fitted with the respective positioning holes.

13. The computing host according to claim 12, wherein the first heat sink is located on a side of the substrate where the computing chips are disposed; the substrate is provided with a first mounting hole, the first heat sink is provided with a second mounting hole corresponding to the first mounting hole, and the second heat sink is provided with a locking hole corresponding to the first mounting hole; wherein the second mounting hole is a stepped hole;
the supercomputing unit further comprises a locking member and an extension spring, the locking member comprises a screw head and a screw shank, the screw shank is locked with the locking hole via the corresponding second mounting hole and the first mounting hole, and the extension spring is located between the screw head and a stepped surface of the stepped hole.

14. The computing host according to claim 1, wherein a plurality of said supercomputing units are disposed side by side in the housing, the first heat sink of one of two said adjacent supercomputing units 20 is adjacent to the second heat sink of the other, and a distance between the two said adjacent supercomputing units is in a range of 2 mm-4 mm.

15. A server, wherein the server comprises the computing host according to claim 1.
